# EUROPEAN PATENT APPLICATION

(11) **EP 4 815 025 A1**
(43) Date of publication of application: **30.09.2026**
(21) Application number: 25166445.4
(22) Date of filing: 26.03.2025
(51) Int. Cl.: H01J 37/22, H01J 37/28, H01J 37/02

(54) **MEASUREMENT APPARATUS AND METHODS**

(71) Applicant: Universiteit van Amsterdam, 1012 WX Amsterdam (NL); Stichting Nederlandse Wetenschappelijk Onderzoek Instituten, 3526 KV Utrecht (NL); Stichting VU, 1081 HV Amsterdam (NL); ASML Netherlands B.V., 5500 AH Veldhoven (NL)
(72) Inventor: PLANKEN, Paulus, Clemens, Maria, 1012 WX Amsterdam (NL); BLIEM, Roland, 1012 WX Amsterdam (NL); FLIERVOET, Timotheus, Fransiscus, 5500 AH Veldhoven (NL)
(74) Representative: ASML Netherlands B.V.

(57) **Abstract**

The present invention relates to a device for determining charge associated with an electric field in a sample subject to a charged-particle beam, the device comprising: an excitation light source configured to emit excitation light toward the sample, the excitation light having an excitation wavelength; a detector configured to detect emission light generated by the sample in response to the excitation light, the emission light having an emission wavelength that is less than the excitation wavelength; and a module configured to determine charge on the sample based on the detected emission light, the charge being associated with the charged-particle beam on the sample.

## Description

### FIELD

The present invention relates to the measurement of electric fields and charge deposited on a substrate, for example during an inspection process using a scanning electron beam.

### BACKGROUND

During manufacturing processes of, for example, semiconductor integrated circuit (IC) chips or displays, undesired defects may occur on a substrate (e.g. wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged-particle systems such as electron microscopes. Such assessment for inspection may relates to defects, for example the existence and classification of such defects. Electron microscopes typically generate a probe beam (also often referred to as primary beam) which may, for example, be scanned across a part of the sample (such as in a scanning electron microscope (SEM)). Collecting interaction products that result from the interaction of the primary beam with the part of the sample, allows the electron microscope to collect data representing the probed part of the sample. The data may be processed/rendered for example by the electron microscope to generate an image representation of the part of the sample. The collected data, for example as a generated image representation, allows for measuring structures on the part of the sample, or allows for identifying defective structures by comparing the image representation with a reference. Such measurement may be referred to as metrology; the identification of defective structures may be referred to as (defect) inspection. The interaction products may contain charged-particles which may be referred to as signal particles (e.g. signal electrons), such as secondary electrons and backscattered electrons, and may contain other interaction products, such as X-ray radiation and even light.

When a sample formed of an insulator or having a low conductivity is scanned with a charged-particle beam, charges may build up in the sample. These charges may be negative, e.g. if the number of electrons emitted from the sample is less than the number of electrons incident in the electron beam, or positive, e.g. if the converse applies. The charges that accumulate may vary from place to place on the sample, depending on scanning patterns and the nature of the sample, especially variations in conductivity and structures on the sample. Charges on the sample generate electric fields that may affect the scanning beam and/or signal particles generated by the scanning beam, distorting images generated by the assessment device. If an exceptionally large charge accumulates, electrical breakdown may damage the sample. The effects of charges that have accumulated in the sample may extend over significant distances, e.g. 10s of µm.

### SUMMARY

An aim of the invention is to provide a means of measuring charges on a sample and/or electric fields generated thereby.

According to an aspect of the invention, there is provided a device for determining charge associated with an electric field in a sample subject to a charged-particle beam, the device comprising:
an excitation light source configured to emit excitation light toward the sample, the excitation light having an excitation wavelength;
a detector configured to detect emission light generated by the sample in response to the excitation light, the emission light having an emission wavelength that is less than the excitation wavelength; and
a module configured to determine charge on the sample based on the detected emission light, the charge being associated with the charged-particle beam on the sample.

According to another aspect of the invention, there is provided a measurement method comprising:
providing a sample to a support structure;
subjecting the sample to a charged-particle beam;
directing excitation light toward the sample, the excitation light comprising light having an excitation wavelength;
detecting emission light generated in the substrate in response to the excitation light, the emission light having an emission wavelength that is less than the excitation wavelength; and
determining charge on the sample based on the detected emission light, the said charge being associated with the charged-particle beam on the sample.

According to another aspect of the invention, there is provided an assessment method comprising:
directing a charged-particle beam along a beam path towards a sample;
detecting signal particles generated in the sample in response to the charged-particle beam to form an image of part of the sample;
directing excitation light toward the sample, the excitation light comprising light having an excitation wavelength;
detecting emission light generated in the substrate in response to the excitation light, the emission light having an emission wavelength that is less than the excitation wavelength;
determining, based on the detected emission light, information of an electric field and/or charge distribution in the sample; and
performing a mitigation based on the information of an electric field and/or charge distribution in the sample.

According to another aspect of the invention, there is provided an assessment method comprising:
flooding a sample with charged-particles;
directing excitation light toward the sample, the excitation light comprising light having an excitation wavelength;
detecting emission light generated in the sample in response to the excitation light, the emission light having an emission wavelength that is less than the excitation wavelength; and
controlling the flooding based on the detection of the emission light.

### BRIEF DESCRIPTION OF THE DRAWINGS

Embodiments of the invention will now be described, by way of example only, with reference to the accompanying schematic drawings, in which:
- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a single beam charged particle-optical device, for example of the assessment apparatus of Figure 1;
- Figure 4 is a schematic diagram of a measurement device of an embodiment;
- Figure 5 is a diagram illustrating polarization states;
- Figure 6 is a schematic diagram of another measurement device according to an embodiment;
- Figure 7 is a diagram of an assessment method of an embodiment of the invention;
- Figure 8 is a flow diagram of a method of the invention;
- Figure 9 is a flow diagram of another method of the invention; and

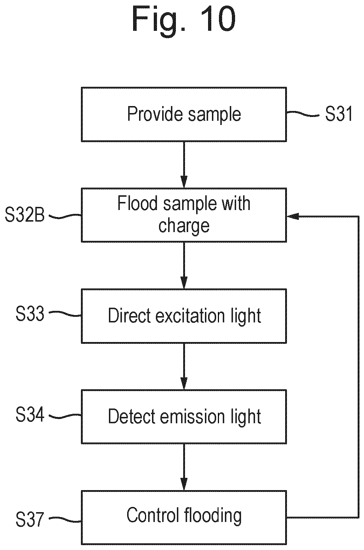

- Figure 10 is a flow diagram of another method of the invention.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged-particles. References to electrons, and items referred to with reference to electrons, throughout the present document may therefore be more generally be considered to be references to charged-particles, and items referred to in reference to charged-particles, with the charged-particles not necessarily being electrons. For example, references to an electron-optical device may more generally be considered to be references to a charged particle-optical device.

### DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7.7%. It is desirable to determine defects quickly so as to maintain a high substrate throughput, defined as the number of substrates processed per hour.

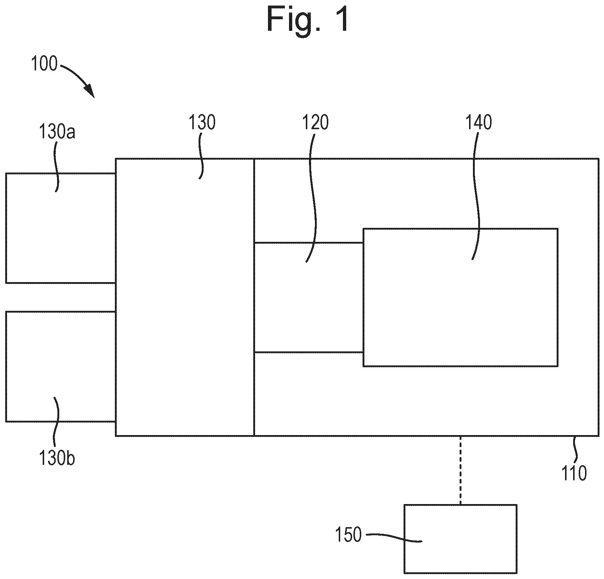

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus compared to a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set, e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

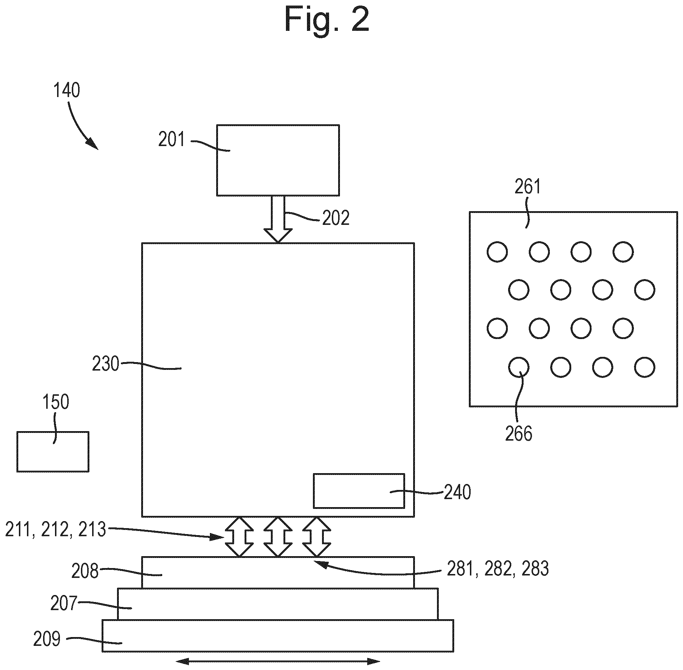

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may also be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to as an array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20 mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid, e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208, which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

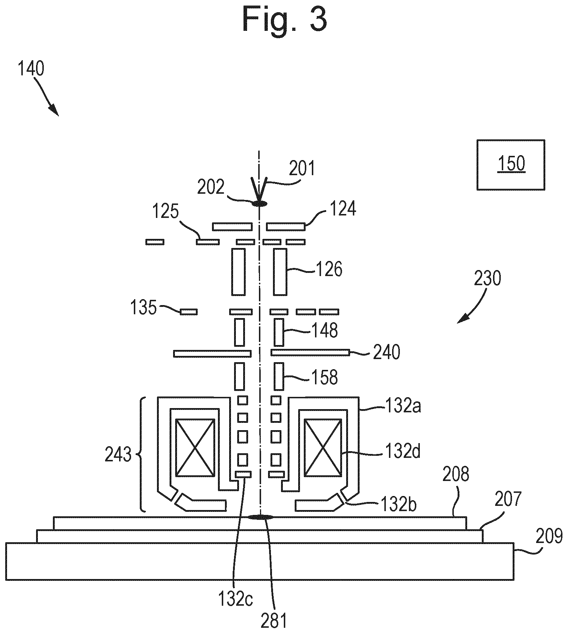

Figure 3 schematically depicts an electron-optical apparatus 140 of an assessment apparatus, e.g. the assessment apparatus 100 of Figure 1. As shown in Figure 3, in an embodiment the electron-optical apparatus 140 comprises an electron-optical device 230 that comprises a beam limit aperture 125 (the image actually shows an array of selectable beam limiting apertures), a condenser lens 126, a column aperture 135 (again indicated as an array of selectable column apertures 135), an objective lens 243 and a detector array 240.

The source 201 is configured to generate a source beam 202. A gun aperture 124 blocks peripheral electrons of the source beam 202. The source beam 202 passes through the beam limit aperture 125, the condenser lens 126 and the column aperture 135. The condenser lens 126 may be magnetic, electrostatic or a combination of magnetic and electrostatic.

In an embodiment the electron-optical device 230 comprises electromagnetic multipole, e.g. quadrupole, electron lenses. For example, the electron-optical device 230 may comprise a first multipole lens 148 and a second multipole lens 158. In an embodiment, the first multipole lens 148 and the second multipole lens 158 are used for controlling the source beam 202. For example, the first multipole lens 148 may be configured to adjust the beam current of the source beam 202. The second multipole lens 158 may be configured to adjust the size of the probe spot 281 and/or the shape of the source beam 202.

The objective lens 243 focuses the source beam 202 onto the sample 208. In an embodiment the objective lens 243 comprises a pole piece 132a, a control electrode 132b, a deflector 132c and an exciting coil 132d. In an embodiment a deflector, such as the deflector 132c or other deflectors in the objective lens 243 are configured to scan the source beam 202 across the surface of the sample 208. The detector array 240 is configured to detect signal electrons from the sample 208.

In an embodiment, the controller 150 is configured to control the electron-optical device 230. The controller 150 may be configured to control potentials applied to electrodes of lenses of the electron-optical device 230.

In an embodiment the controller 150 is configured to control the actuatable stage 209 to move the sample 208 during inspection of the sample 208. The controller 150 may enable the actuatable stage 209 to move the sample 208 in a direction, for example continuously, such as at a constant speed, at least during sample inspection, which may be referred to as a type of scanning. The speed of the actuatable stage 209 may be referred to as the moving rate. The controller 150 may control movement of the actuatable stage 209 so as to change the speed of movement of the sample 208 relative to the beam paths dependent on one or more parameters. The controller 150 may control deflection of scan deflectors so that the beam paths move relative to the actuatable stage 209 and thus over the surface of the sample 208. The controller 150 may change a beam deflection of a scan deflector and thus the scanning of the primary beams 211, 212, 213 over the sample 208 dependent on one or more parameters. For example, the controller 150 may control a scan deflector and/or the speed of the actuatable stage 209 and/or the direction of movement of the actuatable stage 209 depending on characteristics of the assessment process. The disclosure in EP4086933 A1 of a combined stepping and scanning strategy of the stage and scanning deflectors is hereby incorporated by reference. The moving rate may at different times comprise a stepping frequency and/or a stage scanning rate.

When a sample, e.g. a semiconductor or semi-insulator substrate, is scanned with a charged-particle beam, e.g. an electron beam, charges can accumulate in the sample. The charges may be either positive or negative. In the case of an e-beam, the charge that accumulates on the sample may be negative if fewer electrons are emitted from sample than are incident in the e-beam. The accumulated charges may be positive if the number of electrons that are emitted is greater than the number of incident electrons. The sample may be grounded so that charges that accumulate drain away. However, parts of the sample may be insulated or have a high resistance path to ground so that accumulated charge does not drain away or drains away at different rates from different areas. Accordingly, an uneven charge distribution may accumulate in the sample, especially near the surface thereof.

Areas of accumulated charge on the sample give rise to electrostatic fields which affect the assessment process, e.g. by deflecting the scanning electron beam or deflecting signal particles that are emitted from the sample. The effect of areas of accumulated charge may extend over significant distances, e.g. up to tens of microns. The range of effects of accumulated charge may therefore be greater than the distance between electron beams in a multi-beam apparatus or greater than the distance between scan lines in a scan performed by a single beam apparatus.

Various techniques have been developed to address problems caused by accumulated charge on a sample that is being assessed by an e-beam apparatus. For example, it has been proposed to flood the sample with charged-particles prior to the assessment scan so that the sample is uniformly charged and therefore electric fields varying across the area of the sample do not arise. Another approach is to direct electromagnetic radiation to the sample to generate charge carriers (e.g. electron-hole pairs) to increase conductivity and cause accumulated charges to drain away. This latter method is sometimes known as advanced charge control or ACC. However, existing methods for addressing accumulated charges are not entirely successful and further improvements are desirable.

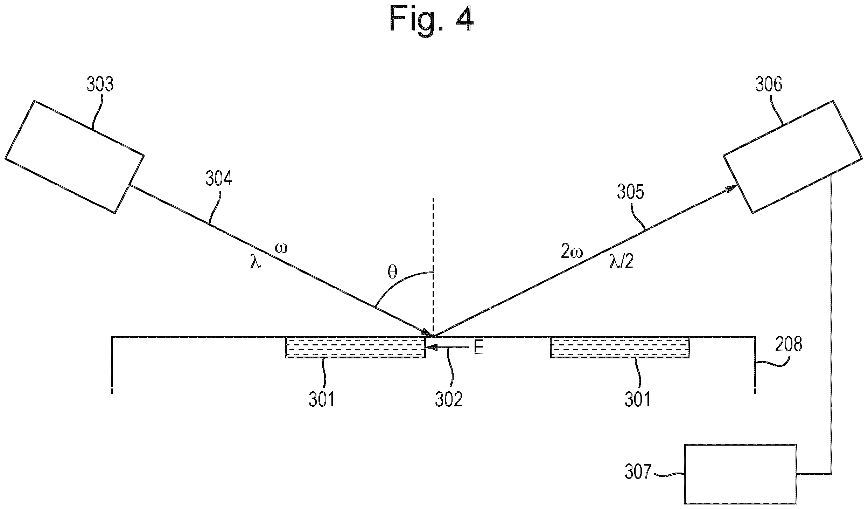

The invention provides devices and methods for determining charge associated with an electric field in a sample that is or has been subjected to a charged-particle beam. As depicted in Figure 4, which is a schematic diagram of an embodiment, an excitation light source 303 is configured to emit excitation light 304 toward the sample 208. The excitation light has an excitation wavelength λ (i.e. a center wavelength) and excitation frequency ω and is directed toward the sample 208 at an angle of incidence θ. The excitation light 304 interacts with an electric field 302 in or in the vicinity of the sample 208 that is generated by a region of accumulated charge 301. By a process known as electric field induced second harmonic generation (E-FISH or E-FISHG) emission light 305 is generated having a frequency 2ω and a wavelength λ/2. The emission light is detected by a detector 306. A module, for example, a calculation module 307 determines whether a region of accumulated charge 301 is present on the sample 208 based on the detection of emission light 305 by detector 306. The excitation light source 303, detector 306 and any associated optical systems may be included in a electron-optical device at a convenient location.

The E-FISH phenomenon is a non-linear phenomenon and the generation of the second harmonic radiation is dependent on the presence of a static or semi-static electric field and its magnitude. Thus, the existence of an electric field arising from accumulated charge in the sample can be deduced from the detection of the emission light 305. By detecting the magnitude of the emission light it is possible to obtain information about the magnitude and direction of the electric field 302 and the magnitude of accumulated charge 301. Determination of the magnitude of electric field E and/or the accumulated charge from the detection of emission light 305 may be done by theoretically or empirically derived relationships. In some use cases, it may be sufficient to determine whether parts of the sample are positively or negatively charged.

In the normal E-FISH phenomenon, two photons of the excitation light combine to form one photon of the emission light, therefore it has twice the frequency and half the wavelength. By conservation of momentum, the emission light will initially be directed along the same path as the excitation light but may then be scattered or reflected by interfaces between layers in the sample out of the sample. The emission light can easily be separated from any reflected excitation light by a wavelength or colour filter. The excitation light can have a wavelength in the range of from about 400 nm to about 2000 nm. A convenient wavelength is about 1000 nm which results in generation of second harmonic light having a wavelength of 500 nm. Light sources with a wavelength of 1030 nm are widely available. In this example, the excitation light is infrared and can be generated at a suitable power whilst the emission light is in the visible spectrum and is detected. The excitation light may be essentially monochromatic or have a narrow bandwidth around a central wavelength, which can be considered the excitation wavelength. If the excitation wavelength has a certain bandwidth, the emission wavelength will have a bandwidth approximately half as large.

If the sample 208 is a semiconductor, it is desirable that the excitation light has a photon energy that is below the semiconductor bandgap. This avoids the generation of charge carriers which might change the charge distribution that is being measured and reduces the risk of high currents that might damage the sample. If the sample has a photosensitive material, e.g. a layer of resist, it is desirable that the photon energy of the excitation light is lower than the threshold at which the photosensitive material is modified.

To generate a detectable intensity of the emission radiation even if the electric fields in the sample are not strong, a high local intensity of the excitation radiation is desirable. However, it is also desirable that the excitation light intensity not be high enough to cause damage to the sample. Suitable intensity values can be determined by experiment.

Desirably, excitation light source 303 is configured to emit pulsed light as the excitation light. By use of a pulsed light source, it is possible to achieve a high local peak power for enhanced second harmonic generation but the time-averaged power can be low so as not to overheat or damage the sample. A femto-second laser may be used to generate high-power, short-duration pulses.

Desirably, excitation light is coherent but a long coherence length is not necessary. If the excitation light is pulsed, the coherence length may be similar to the pulse length.

In a variant, excitation light source 303 emits first excitation light and second excitation light having first excitation center wavelength ω₁ and second excitation center wavelength ω₂ respectively. The first excitation center wavelength and second excitation center wavelengths are different. In this arrangement, the E-FISH phenomenon results in photons of the first excitation light combining with photons of the second excitation light to generate photons having a frequency equal to the sum of the angular frequencies of the first and second excitation lights (ω_{1 +} ω₂). Therefore the emission light has a wavelength : 2.π.c/(ω_{1 +} ω₂) (where c is the speed of light), which is less than the wavelength of either of the first and second excitation lights. The first and second excitation lights may be directed to the sample from different directions so as to intersect at a point where an electric field is to be measured. In such a configuration, the direction of emission of the emission light will be determined by the conservation of momentum and dependent on the incident directions.

Polarization can be used to determine the electric field strength in different directions. If the excitation light is directed onto the sample at normal incidence, the excitation light is polarized parallel to the sample surface, which enables information about in-plane (parallel to the surface) electric fields to be obtained. Knowing, or varying, the relative magnitudes and phases of two orthogonal polarization states, and measuring the emission light in two corresponding polarization directions provides information about the direction of the field in the plane of the sample. The polarization states may be linear or circular.

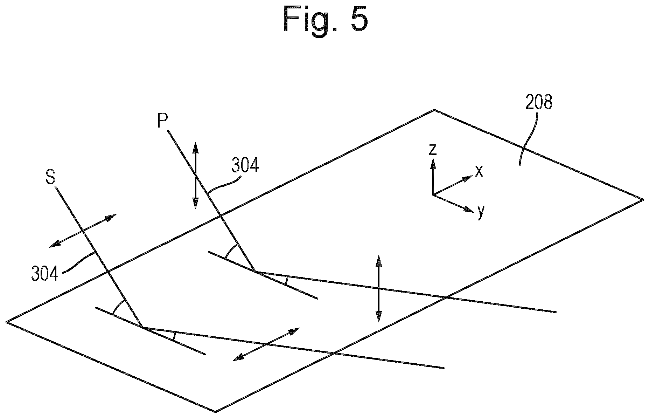

If the direction of incidence of excitation light is not orthogonal or at a non-normal angle of incidence to the surface (i.e. angle of incidence relative to the normal is > 0) information about the electric field component perpendicular to the surface can be obtained. Assuming a coordinate system in which the z-direction is perpendicular to the surface of the sample, and the x- and y-directions are in-plane and mutually orthogonal, and that the beam direction is in the yz plane, as depicted in Figure 5. If the polarization of the beam is then parallel to the x-axis (s-polarized light), information about the static electric field component oriented in the x-direction can be obtained. If the polarization instead is in the yz plane (p-polarized light), information about the effect of both the static field components in the y-direction, and those in the z-direction can be obtained. By rotating the beam relative to the sample by 90 degrees around the z-axis, information about the y-component exclusively can be obtained by again using s-polarized light.

Detector 306 is desirably a sensitive detector such as a photomultiplier or an avalanche photodiode. Wavelength filters to exclude reflected excitation light and/or other stray light may be included. Polarizers and/or quarter- or half-waveplates may be included to enable measurement of polarization.

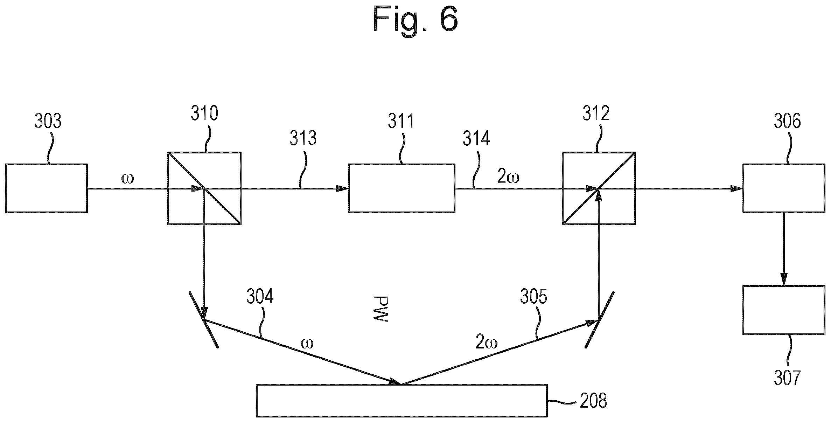

Figure 6 depicts a variant of the embodiment of Figure 4 in which homodyne detection is used to determine both phase and amplitude information of the emission radiation 305. Parts in Figure 6 having the same reference numerals as parts in Figure 4 are the same.

In Figure 6 the excitation light source 303 directs light at frequency ω to a beam splitter 310 which divides the excitation light into a first excitation light beam 304 and a second excitation light beam 313. The first excitation light source may be modulated. The first excitation light beam 304 is directed to the sample 208 to generate emission beam 305 via E-FISH. The second excitation light beam 313 is directed to a second harmonic generator 311, e.g. a non-linear crystal, which generates a second harmonic reference beam 314 with frequency 2ω. A second beam splitter 312 recombines the second harmonic reference beam 314 and the emission beam 305 and directs them to detector 306. Interference between the second harmonic reference beam 314 and emission light 305 can provide information about the phase of the emission radiation and increases sensitivity by amplifying the emission light 305 through mixing with the second harmonic reference beam 314.

To derive information about the distribution of charge in the substrate, e.g. in the form of a map, the excitation light 304 can be directed to a small spot on the sample. The sample and/or the excitation light are then scanned, e.g. in a raster pattern, whilst the emission light 305 is detected so as to obtain information about electric fields, and hence electric charge, at different positions on the sample.

Alternatively, the emission light 304 can be directed in a broader beam to illuminate a region of the sample 208. An imaging microscope can then be used to obtain an image of the emission light 305 emitted from the region. Information about field distribution, and hence charge distribution, across the whole of the illuminated region of the sample can then be obtained from the image.

Measurement devices of embodiments of the invention are desirably incorporated into an assessment device using an electron beam to assess samples. The measurement device may be located at an assessment station of the assessment device, i.e. at the point where the sample is inspected, or at a separate measurement station. A measurement device of an embodiment may be incorporated into the electron-optic column 230 so as to measure fields and/or charge in the sample close to the probe spot(s) 281-283. Mitigations for the effects of charge and/or fields in the sample may therefore be applied in a feedback loop with a short delay.

In a measurement method according to an embodiment, the measurement of fields and/or charge at certain points on a sample are repeated at time intervals. In this way, the evolution of fields and/or charges in the sample can be measured. In particular, it is possible to obtain information about the rate of charge dissipation or diffusion in the sample 208. Such information may be helpful in determining mitigation strategies, for example scanning speeds and/or routes. In some cases, anomalous rates of charge dissipation may be indicative of defects in the sample being assessed.

A measurement method of an embodiment may be performed during, or at intervals in, an assessment process using a charged-particle beam. A change in the charge and/or fields in the sample may be indicative of damage to the sample caused by the charged-particle beam, amongst other things.

A measurement method of an embodiment may be performed during, or at intervals in, a charge flooding or charge control process. The measurement of fields and/or charge during such a process can provide information as to the progress or effect of the charge flooding or charge control process. This can improve throughput by allowing the charge flooding or charge control process to be terminated as soon as a desired effect is achieved or improve effectiveness by ensuring that the charge flooding or charge control process is not terminated until a desired effect is achieved.

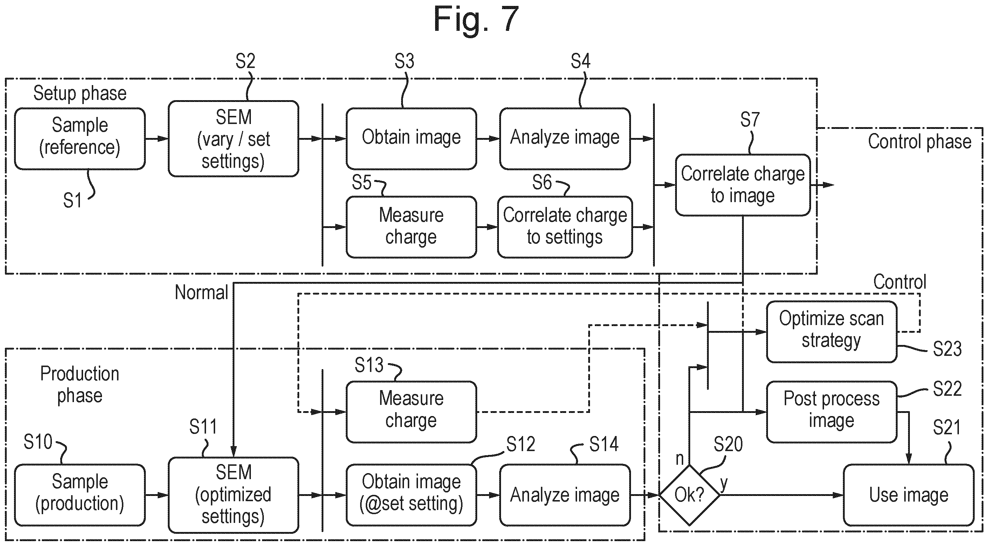

Figure 7 depicts an assessment process incorporating a charge measurement method of an embodiment to improve assessment samples. In a set up phase, a reference sample is provided S1 and scanned S2 with a scanning electron microscope. During this step the settings of the scanning electron microscope may be set and varied as desired. If desired, multiple samples may be scanned. An assessment image is obtained S3 and analyzed S4, e.g. to identify defects and/or features in the sample. In parallel with obtaining the assessment image, charge on the sample is measured S5 at different locations thereof. Correlations between the distribution of charge on the sample and the settings of the scanning electron microscope are obtained S6. The assessment image is then used to determine correlations S7 between features and/or defects of the sample and the charge in the sample.

In a production phase, a production sample S10 is provided and scanned S11 using optimized settings of the scanning electron microscope. The production assessment image is obtained S12 and analyzed S14. In parallel, charge in the production sample is measured S13. It should be noted that parallel measurement of charge and assessment of a sample can include exactly simultaneous assessment and charge measurement or charge measurement a short delay after assessment.

In a control phase the image of the production sample can be checked S20 to see if it is useable. If it is usable, the image is used S21 to determine whether or not the production sample has defects. If the production assessment image is determined not to be usable, a post processing step S22 can be performed using the measurement of charge on the sample substrate to correct or improve the production assessment image as required. In addition, information on charge can be used to optimize S23 the assessment scan strategy. The optimized assessment scan strategy can be applied to assessment of subsequent samples or used in a feedback loop to improve a current assessment process.

Optimization of the scan strategy may include one or more of:
- changing a scanning path of the sample;
- changing a scanning speed or dwell time of the sample;
- changing a landing energy of the charged-particle beam;
- changing a beam current of the charged-particle beam; and
- changing a pulse rate and/or duty cycle of the charged-particle beam.

Other mitigation strategies may include one or more of:
- directing electromagnetic radiation on the sample to generate charge carriers;
- providing a conductive gas or plasma in the vicinity of the sample to enhance dissipation of charge; and
- flooding the sample with charged-particles.

Since semiconductor devices are often manufactured and assessed in large batches, it is useful to apply information on charge accumulation derived in the assessment of one sample to improve the manufacture or assessment of subsequent identical or similar samples. This may include the above mitigations or other mitigations such as applying a coating to reduce charge accumulation, if warranted.

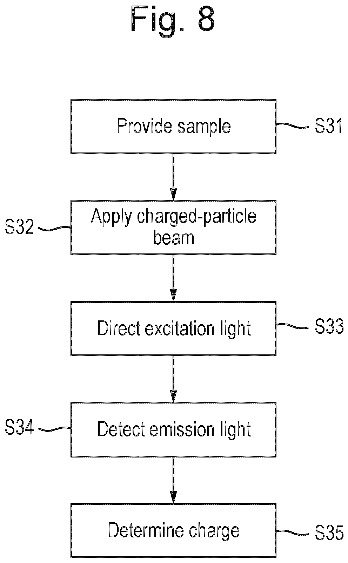

A measurement method of an embodiment of the invention is depicted in Figure 8. This method comprises:
- providing S31 a sample to an assessment apparatus;
- applying S32 a charged-particle beam to the sample;
- directing S33 excitation light to the sample;
- measuring S34 emission light from the sample as a result of the excitation light directed thereon; and
- determining S35 a distribution of electric fields and/or charge in the sample on the basis of the measured emission light.

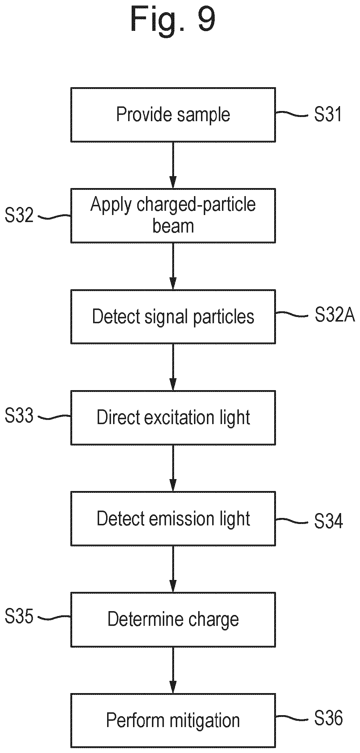

An assessment method of an embodiment of the invention is depicted in Figure 9. This method comprises:
- providing S31 a sample to an assessment apparatus;
- applying S32 a charged-particle beam to the sample;
- detecting S32A signal particles emitted by the sample in response to the charged-particle beam;
- directing S33 excitation light to the sample;
- measuring S34 emission light from the sample as a result of the excitation light directed thereon;
- determining S35 a distribution of electric fields and/or charge in the sample on the basis of the measured emission light; and
- performing S36 a mitigation to improve the assessment of the sample using the signal particles.

Another assessment method of an embodiment of the invention is depicted in Figure 9. This method comprises:
- providing S31 a sample to an assessment apparatus;
- flooding S32B the sample with charged-particles;
- directing S33 excitation light to the sample;
- detecting S34 emission light from the sample as a result of the excitation light directed thereon; and
- controlling S37 the flooding process on the basis of the detection of emission light.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other substrate) or mask (or other patterning device).

Although specific reference may have been made above to the use of embodiments of the invention in the context of sample assessment, it will be appreciated that the invention, where the context allows, is not limited to sample assessment and may be used in other applications, for example electron beam lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Embodiments of the invention are described below in the following numbered clauses:
1. A device for determining charge associated with an electric field in a sample subject to a charged-particle beam, the device comprising:
   an excitation light source configured to emit excitation light toward the sample, the excitation light having an excitation wavelength;
   a detector configured to detect emission light generated by the sample in response to the excitation light, the emission light having an emission wavelength that is less than the excitation wavelength; and
   a module, for example, a calculation module configured to determine charge on the sample based on the detected emission light, the charge being associated with the charged-particle beam on the sample.
2. A device according to clause 1 wherein the excitation light source is configured to emit the excitation light having a narrow bandwidth about the excitation wavelength and wherein the emission wavelength of the emission light is approximately equal to half the excitation wavelength of the excitation light, the detector being configured to measure the emission lighthaving the said emission wavelength .
3. A device according to clause 1 wherein the excitation light is a first excitation light having a first excitation wavelength and a corresponding first angular frequency and wherein the excitation light source is further configured to emit a second excitation light having a second excitation wavelength and a corresponding second angular frequency, wherein the emission wavelength of the emission light corresponds to a sum of the first angular frequency and the second angular frequency, the detector being configured to detect the said emission light .
4. A device according to any preceding clause wherein the excitation light has a wavelength in the range of from 400 nm to 2000 nm.
5. A device according to any one of clauses 1 to 4 wherein the excitation light source is configured to direct excitation light to be incident normally on the sample.
6. A device according to any one of clauses 1 to 5 wherein the excitation light source is configured to direct excitation light to be incident on the sample at an angle of incidence greater than 0.
7. A device according to any one of the preceding clauses wherein the excitation light source is configured to emit pulsed light as the excitation light.
8. A device according to any one of the preceding clauses wherein the excitation light source is configured to emit excitation light having a photon energy less than the bandgap of the sample.
9. A device according to any one of the preceding clauses wherein the detector is configured to measure an intensity of emission light from a location, preferably a single location, on the sample.
10. A device according to any one of clauses 1 to 8 wherein the detector is configured to form an image of the emission light emitted from an area of the sample.
11. A device according to any one of the preceding clauses wherein the detector is configured to measure a polarisation of the emission light.
12. A charged particle-optical device configured to direct one or more charged-particle beams along one or more respective beam paths towards a sample location, the charged particle-optical device comprising the device of any preceding clause.
13. An assessment apparatus for assessing a sample, comprising:
   the charged particle-optical device of clause 12;
   a support structure for supporting the sample; and
   a control means to control one or more parameters of an assessment process using the charged particle beam based on the determined charge.
14. An assessment apparatus according to clause 13 wherein the control means is configured to control the one or more parameters to mitigate the effect of charge build up.
15. A measurement method comprising:
   providing a sample to a support structure;
   subjecting the sample to a charged-particle beam;
   directing excitation light toward the sample, the excitation light comprising light having an excitation wavelength;
   detecting emission light generated in the sample in response to the excitation light, the emission light having an emission wavelength that is less than the excitation wavelength; and
   determining charge on the sample based on the detected emission light, the said charge being associated with the charged-particle beam on the sample.
16. A method according to clause 15 further comprising repeating, after a period of time, the steps of directing excitation light and detecting emission light; and
   determining a change in charge distribution in the sample based on the detections emission light.
17. An assessment method comprising:
   directing a charged-particle beam along a beam path towards a sample;
   detecting signal particles generated in the sample in response to the charged-particle beam to form an image of at least a part of the sample;
   directing excitation light toward the sample, the excitation light comprising light having an excitation wavelength;
   detecting emission light generated in the sample in response to the excitation light, the emission light having an emission wavelength that is less than the excitation wavelength;
   determining, based on the detected emission light, information of an electric field and/or charge distribution in the sample; and
   performing a mitigation based on the information of an electric field and/or charge distribution in the sample.
18. A method according to clause 17 wherein the mitigation comprises one or more of:
   i changing a scanning path of the sample;
   ii changing a scanning speed of the sample;
   iii changing a landing energy of the charged-particle beam;
   iv changing a beam current of the charged-particle beam;
   v changing a pulse rate and/or duty cycle of the charged-particle beam;
   vi post-processing of the image of part of the sample;
   vii directing electromagnetic radiation onto the sample to generate charge carriers;
   viii flooding the sample with charged particles;
   ix providing a conductive gas or plasma in the vicinity of the sample; and
   x changing a parameter of a recipe for assessment of a subsequent sample.
19. An assessment method comprising:
   flooding a sample with charged-particles;
   directing excitation light toward the sample, the excitation light comprising light having an excitation wavelength;
   detecting emission light generated in the sample in response to the excitation light, the emission light having an emission wavelength that is less than the excitation wavelength; and
   controlling the flooding based on the detection of the emission light.
20. A method according to any one of clauses 15 to 19 wherein the sample is a semiconductor or semi-insulator.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

### List of reference numerals:

100 assessment apparatus
110 vacuum chamber (main chamber)
120 load lock chamber
124 gun aperture
125 beam limit aperture
130 EFEM
130a first loading port
130b second loading port
132a pole piece
132b control electrode
132c deflector
132d exciting coil
135 column aperture
140 electron-optical apparatus (electron beam apparatus, electron apparatus)
150 controller
158 second multipole lens
201 source
202 source beam
207 sample holder
208 sample
209 actuatable stage
211, 212, 213 primary beams (sub-beams, beamlets)
230 electron-optical device (electron-optical column)
240 detector array
261 plate
266 beam apertures
281-283 probe spots
301 charge region
302 electric field
303 excitation light source
304 excitation light
305 emission light
306 detector
307 calculation module
310, 312 beam splitter
311 non-linear crystal
313 second excitation light beam
314 second harmonic reference beam

## Claims

1. A device for determining charge associated with an electric field in a sample subject to a charged-particle beam, the device comprising:
an excitation light source configured to emit excitation light toward the sample, the excitation light having an excitation wavelength;
a detector configured to detect emission light generated by the sample in response to the excitation light, the emission light having an emission wavelength that is less than the excitation wavelength; and
a module configured to determine charge on the sample based on the detected emission light, the charge being associated with the charged-particle beam on the sample.

2. A device according to claim 1, wherein the excitation light source is configured to emit the excitation light having a narrow bandwidth about the excitation wavelength, wherein the emission wavelength of the emission light is approximately equal to half the excitation wavelength of the excitation light, the detector being configured to measure the emission light having the said emission wavelength.

3. A device according to any preceding claim wherein the excitation light has a wavelength in the range of from 400 nm to 2000 nm.

4. A device according to any one of claims 1 to 3 wherein the excitation light source is further configured to direct the excitation light to be incident normally on the sample.

5. A device according to any one of claims 1 to 3 wherein the excitation light source is further configured to direct the excitation light to be incident on the sample at a non-normal angle of incidence.

6. A device according to any one of the preceding claims wherein the excitation light source is further configured to emit pulsed light as the excitation light.

7. A device according to any one of the preceding claims wherein the sample comprises a semiconductor and the excitation light source is configured to emit the excitation light having a photon energy less than the bandgap of the semiconductor.

8. A device according to any one of the preceding claims wherein the detector is further configured to measure an intensity of the emission light from a location on the sample.

9. A device according to any one of claims 1 to 7 wherein the detector is further configured to form an image of the emission light emitted from an area of the sample.

10. A device according to any one of the preceding claims wherein the detector is further configured to measure a polarisation of the emission light.

11. A charged particle-optical device configured to direct one or more charged-particle beams along one or more respective beam paths towards a sample location, the charged particle-optical device comprising the device of any preceding claim.

12. An assessment apparatus for assessing a sample, comprising:
the charged particle-optical device of claim 11;
a support structure for supporting the sample; and
a control means to control one or more parameters of an assessment process using the charged particle beam, based on the determined charge.

13. An assessment apparatus according to claim 12 wherein the control means is configured to control the one or more parameters to mitigate an effect of charge build-up.

14. A measurement method comprising:
providing a sample to a sample support structure;
subjecting the sample to a charged-particle beam;
directing excitation light toward the sample, the excitation light comprising light having an excitation wavelength;
detecting emission light generated in the sample in response to the excitation light, the emission light having an emission wavelength that is less than the excitation wavelength; and
determining charge on the sample based on the detected emission light, the said charge being associated with the charged-particle beam on the sample.

15. A method according to claim 14 further comprising:
repeating, after a period of time, the steps of directing excitation light and detecting the emission light; and
determining a change in charge distribution in the sample based on the said detection of the emission light.
